# EUROPÄISCHE PATENTSCHRIFT

(11) **EP 1 854 142 B1**
(45) Veröffentlichungstag und Bekanntmachung des Hinweises auf die Patenterteilung: **03.09.2008**
(21) Anmeldenummer: 06708118.2
(22) Anmeldetag: 08.02.2006
(51) Int. Cl.: H01L 27/146, H01L 31/0203, G02B 6/42

(54) **BILDAUFNAHMESYSTEM, Herstellungsverfahren und Fertigungsvorrichtung dazu**
IMAGE RECORDING SYSTEM, method and apparatus to manufacture it
SYSTEME DE PRISE DE VUES, procédé et dispositif de fabrication

(30) Priorität: 15.02.2005 DE 102005006756
(43) Veröffentlichungstag der Anmeldung: 14.11.2007
(73) Patentinhaber: ROBERT BOSCH GMBH, 70442 Stuttgart (DE)
(72) Erfinder: GOTTWALD, Frank, 71287 Weissach (DE); KNEE, Werner, 73728 Esslingen (DE); SCHICK, Jens, 71083 Herrenberg (DE)
(86) Internationale Anmeldenummer: PCT/EP2006/050773
(87) Internationale Veröffentlichungsnummer: WO 2006/087286

(56) Entgegenhaltungen:
- EP-A- 1 475 960
- WO-A-03/088204
- WO-A-03/105099

## Beschreibung

### Stand der Technik

Die Erfindung betrifft ein Bildaufnahmesystem nach dem Oberbegriff des Anspruchs 1. Ein Bildaufnahmesystem der gattungsgemäßen Art wird vorzugsweise in Kraftfahrzeugen eingesetzt, um Bilder des Fahrzeugumfelds zu gewinnen, und, in Verbindung mit Assistenzsystemen, dem Fahrer die Führung des Fahrzeugs zu erleichtern. Ein derartiges Bildaufnahmesystem umfasst wenigstens einen Bildsensor und ein diesem Bildsensor zugeordnetes optisches Modul, das ein Aufnahmefeld des Bildaufnahmesystems aus dem Fahrzeugumfeld auf den Bildsensor abbildet.

Aus der DE 199 17 438 A1 sind eine Schaltungsanordnung und ein Verfahren zur Herstellung einer Schaltungsanordnung bekannt, wobei die Schaltungsanordnung eine Leiterplatte und einen auf dieser angeordneten Bildaufnehmer umfasst. Ferner wird ein Objektivhalter zur Aufnahme und Befestigung von optischen Elementen vorgeschlagen. Hinweise auf ein Bildaufnahmesystem mit einem einfachen Aufbau bei gleichzeitig hoher Genauigkeit des Bildaufnahmesystems fehlen in der DE 199 17 438 A1.

Aus der EP 1475 960 A2 ist ein Kameramodul und ein Verfahren zur Herstellung des Kameramoduls bekannt Die WO 03/105099 A1 offenbart ein Innenrückspiegelsystem mit einem Kompass. Aus der WO 03/088204 A1 ist ein Joystick zur Steuerung eines Computers bekannt.

### Vorteile der Erfindung

Das nachfolgend beschriebene Bildaufnahmesystem, insbesondere zur Verwendung in einem Kraftfahrzeug, besteht aus wenigstens einem Bildsensor, einem optischen Modul, einem Gehäuse und einem den Bildsensor tragenden, in seiner Ausrichtung innerhalb des Gehäuses justierbaren und in einer Justierlage fixierbaren Träger. Dadurch dass das optische Modul gehäusefest angeordnet ist, der Bildsensor aber zusammen mit einer Leiterplatte auf dem justier- und fixierbaren Träger angeordnet ist, können das optische Modul und der Bildsensor unter Einhaltung relativ grober Toleranzwerte zunächst getrennt voneinander montiert werden. Eine für eine hohe Qualität des Bildaufnahmesystems erforderliche exakte Justierung von Bildsensor und optischem Modul wird durch eine Ausrichtung und anschließende Fixierung des den Bildsensor tragenden Trägers erreicht.

Vorteilhaft ist das optische Modul in einem in Bezug auf das Gehäuse zentrisch orientierten Tubus angeordnet, wobei zur Aufnahme des optischen Moduls eine Gewindeaufnahme vorgesehen ist. Eine Gewindeaufnahme bietet viele Vorteile. Zum einen ist die Montage des optischen Moduls durch Eindrehen desselben in das Gehäuse einfach und positionsgenau möglich. Ferner bietet die Gewindeaufnahme die Möglichkeit, in einfacher Weise die Bildschärfe des Bildsensors durch Ein- oder Ausdrehen des optischen Moduls einzustellen.

Besonders vorteilhaft ist, dass der Bildsensor auf einer Leiterplatte angeordnet ist, da hierbei kurze Signal- und Energieversorgungswege zu nachgeschalteten Elektronikeinheiten möglich sind. Dies trägt in vorteilhafter Weise zu einer kompakten Bauweise des Bildaufnahmesystems bei. Vorteilhaft ist ferner, dass die bestückte Leiterplatte auf einem justierbaren und in einer Justierlage fixierbaren Träger angeordnet und dadurch relativ zum Gehäuse positionierbar ist. Vorzugsweise ist der Träger aus Aluminium oder einer Aluminiumlegierung gefertigt. Hierdurch werden auch eine hohe mechanische Stabilität und eine hohe Vibrationstoleranz des Bildaufnahmesystems erreicht, welches sich hierdurch insbesondere für den Einsatz in der Kraftfahrzeugtechnik, also zum Einbau in ein Kraftfahrzeug, eignet.

Vorteilhaft ist ferner, dass in Abhängigkeit von Bilddaten eines von dem optischen Modul auf den Bildsensor projizierten Testbilds die Bildschärfe eingestellt wird, indem die Position des den Bildsensor tragenden Trägers in dem Gehäuse des Bildaufnahmesystems verstellt wird, da hierbei in einem Herstellungsprozess sowohl die Ausrichtung des Bildsensors zu dem gehäusefest angeordneten optischen Modul als auch die Bildschärfe eingestellt werden.

Besonders vorteilhaft ist, dass in Abhängigkeit der Bilddaten von dem Testbild wenigstens ein Einstellparameter des Bildsensors, beispielsweise wenigstens ein Einstellparameter zur intrinsischen Kalibrierung und/oder wenigstens ein Einstellparameter der Fixed Pattern Noise Korrektur ermittelt und gegebenenfalls eingestellt wird, da hierbei noch ein weiterer Einstellvorgang integriert bei der Herstellung des Bildaufnahmesystems durchgeführt wird. Dies führt in vorteilhafter Weise zu einer Reduzierung der Herstellungskosten des Bildaufnahmesystems, wobei das Bildaufnahmesystem gleichzeitig eine hohe Genauigkeit aufweist.

Die oben genannten Vorteile für das Bildaufnahmesystem gelten auch für ein Verfahren zur Herstellung eines erfindungsgemäßen Bildaufnahmesystems.

Weitere Vorteile ergeben sich aus der nachfolgenden Beschreibung von Ausführungsbeispielen mit Bezug auf die Figuren und aus den abhängigen Patentansprüchen.

### Zeichnung

Die Erfindung wird nachstehend anhand der in der Zeichnung dargestellten Ausführungsformen näher erläutert.

Es zeigen:

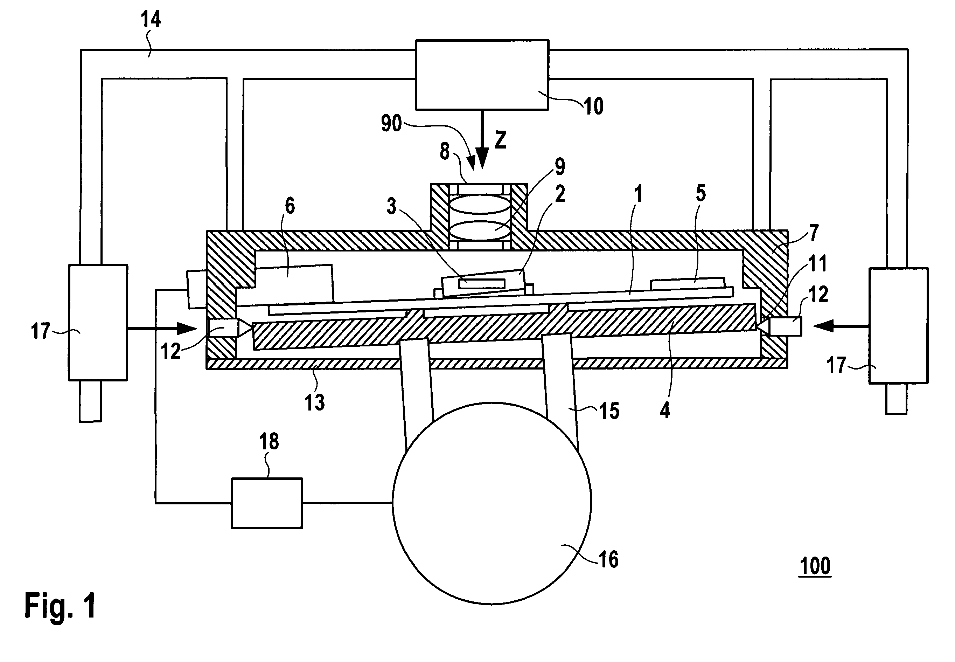

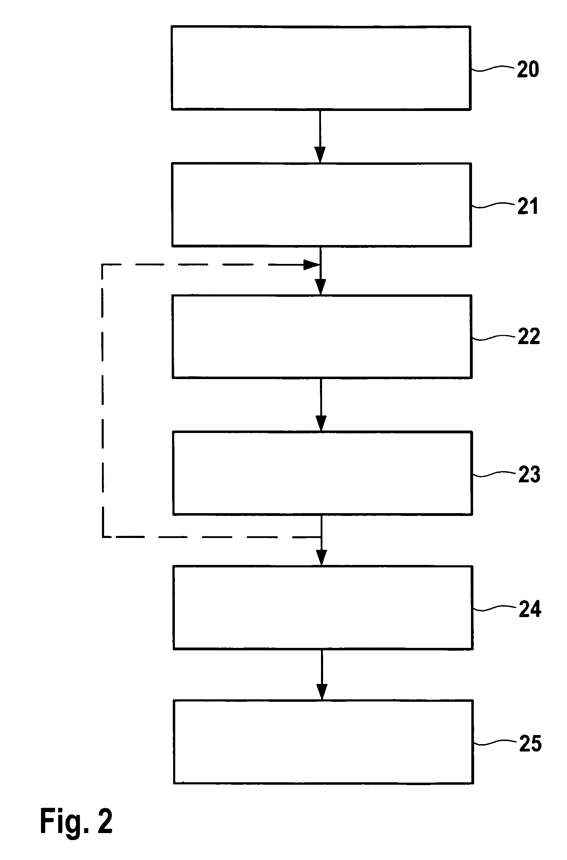

Figur 1 ein Bildaufnahmesystem des bevorzugten Ausführungsbeispiels, Figur 2 ein Ablaufdiagramm des Verfahrens des bevorzugten Ausführungsbeispiels.

### Beschreibung von Ausführungsbeispielen

Nachfolgend werden, unter Bezug auf die Figuren, ein Bildaufnahmesystem, insbesondere zur Verwendung in einem Fahrzeug, ein Verfahren zur Herstellung eines derartigen Bildaufnahmesystems, sowie eine Fertigungseinrichtung für die Herstellung eines derartigen Bildaufnahmesystems beschrieben. Ein für den mobilen Einsatz in einem Fahrzeug, insbesondere in einem Kraftfahrzeug, vorgesehenes Bildaufnahmesystem muss einerseits sehr robust sein, damit es den mit dem Kranfahrzeugbetrieb verbundenen rauen Betriebsbedingungen standhält. Diese Betriebsbedingungen beinhalten eine Temperaturbeständigkeit über einen sehr weiten Temperaturbereich, eine hohe Schockfestigkeit, Spritzwasserbeständigkeit und dergleichen. Zugleich soll das Bildaufnahmesystem aber auch sehr genau sein und einen Aufnahmebereich aus dem Fahrzeugumfeld auch unter widrigen Sichtbedingungen möglichst scharf und detailgetreu abbilden. Gleichzeitig soll das Bildaufnahmesystem jedoch preiswert herstellbar sein, um seinen Einsatz in der Großserienfertigung von Fahrzeugen attraktiv zu machen. Eine große Genauigkeit des Bildaufnahmesystems könnte beispielsweise durch eine extrem präzise Fertigung der Komponenten des Bildaufnahmesystems erfolgen, die für die optische Justierung der abbildenden Elemente zuständig sind. Eine derartige Lösung kann jedoch nur mit zusätzlichem Aufwand in der Konstruktion erreicht werden. Eine solche Lösungsmöglichkeit ist, im Allgemeinen, mit erhöhten Kosten verbunden. Diese Kosten wären überdies nur für den Vorgang der Montage notwendig, nicht aber für den Betrieb des Bildaufnahmesystems. Die Erfindung geht daher von der Erkenntnis aus, dass sich ein optisch hochwertiges Bildaufnahmesystem wesentlich kostengünstiger herstellen lässt, wenn vergleichsweise grob tolerierte Komponenten in einer hochpräzisen Fertigungseinrichtung optimal aufeinander justiert und dann in dieser Justierlage dauerhaft fixiert werden. Das in Figur 1 dargestellte Bildaufnahmesystem 100 umfasst einen Bildsensor 3, der ggf. von einem lichtdurchlässigen Gehäuse 2 umgeben, auf einer Leiterplatte 1 befestigt ist. Die Befestigung des Bildsensors 3 auf der Leiterplatte 1 erfolgt mittels bekannter Klebstoffe und/oder mittels eines Lötprozesses, der gleichzeitig eine elektrische Verbindung des Bildsensors mit den zusätzlich auf der Leiterplatte 1 angeordneten elektrischen und elektronischen Komponenten ermöglicht. Lediglich beispielhaft sind noch ein elektronisches Element 5 und ein Stecker 6 dargestellt, die ebenfalls mit der Leiterplatte 1 verbunden sind. Aufgrund der erfindungsgemäßen Lösung können der Bildsensor 3, bzw. der eventuell in einem Gehäuse 2 verpackte Bildsensor 3, mit relativ groben Toleranzwerten auf der Leiterplatte 1 befestigt werden, was einer kostengünstigen Fertigung dienlich ist. Insbesondere ist es nicht erforderlich, dass die lichtempfindliche Fläche des Bildsensors 3 bereits parallel zu der Oberfläche der Leiterplatte 1 ausgerichtet ist. Die Leiterplatte 1 ihrerseits ist auf einem Träger 4 angeordnet, der für Justierzwecke beweglich in einem Gehäuse 7, 13 gelagert ist. Der Träger 4 ist im bevorzugten Ausführungsbeispiel aus Aluminium oder einer Aluminiumlegierung. Das Gehäuse 7, 13 besteht aus einem im Wesentlichen topfförmigen Grundkörper 7 und einem den Grundkörper 7 verschließenden Deckel 13. Vorzugsweise zentrisch in dem Boden des Gehäuses 7 ist ein Tubus 8 angeordnet, der ein optisches Modul 90 aufnimmt. Das optische Modul 90 besteht aus einer Kombination optischer Elemente 9, die eine Szene aus dem Aufnahmebereich des Bildaufnahmesystems 100 scharf auf den Bildsensor 3 abbilden. Das optische Modul 90 steht somit in optischer Wirkverbindung mit dem Bildsensor 3. Das optische Modul 90 und/oder optische Elemente 9 des optischen Moduls 90 sind wenigstens entlang einer Achse des Gehäuses 7, 13, vorzugsweise in Richtung der auf dem Boden des Gehäuses 7, 13 senkrecht stehenden z-Achse des Gehäuses 7, 13 verstellbar angeordnet, um eine Fokussierung auf den Bildsensor 3 zu ermöglichen. Weiterhin umfasst das Bildaufnahmesystem 100 Fixiermittel, die eine Fixierung des Trägers 4 in einer optimalen Justierlage ermöglichen. Vorzugsweise sind die Fixiermittel 12 Madenschrauben, die sich einerseits an der Innenwandung des Gehäuses 7, 13 abstützen und andererseits den Träger 4 auf seinem Außenumfang mit Anpressdruck beaufschlagen. Im bevorzugten Ausführungsbeispiel weisen die Fixiermittel 12 eine Spitze auf, wobei die Spitze eine höhere Härte aufweist, als die Oberfläche des Trägers 4, an welche die Spitzen angreifen. Vorzugsweise sind die Fixiermittel 12 aus Stahl, wobei die Spitzen bevorzugt gehärtet sind. Die Spitzen der Fixiermittel 12 bohren sich bei der Fixierung etwa einen Millimeter in den Außenumfang des Trägers 4 ein. Die Fixiermittel 12 sind zweckmäßig in Gewindebohrungen in der Wandung des Gehäuses 7, 13 gelagert und in Radialrichtung verstellbar. Vorzugsweise sind wenigstens drei Fixiermittel 12 vorgesehen, die in einem Winkelabstand von 120° auf dem Umfang eines Kreises verteilt angeordnet sind. In einer Variante sind vier Fixiermittel 12 vorgesehen, die an jeder Seite eines rechteckförmigen Trägers 4 angreifen. In einer weiteren Variante sind acht Fixiermittel 12 vorgesehen, wobei an jeder Seite des rechteckförmigen Trägers 4 jeweils 2 Fixiermittel 12 angreifen.

Im Folgenden wird die Montage des Bildaufnahmesystems 100 beschrieben. Um eine Montage des Bildaufnahmesystems 100 zu bewerkstelligen und dabei eine optimale optische Justierung des Bildsensors 3 in Bezug auf das optische Modul 90 zu gewährleisten, wird das Gehäuse 7 in eine Aufnahmeeinrichtung 14 einer Montageeinrichtung eingespannt. Die Aufnahmeeinrichtung trägt eine Mehrzahl von Schraubern 10, 17. Mittels des Schraubers 10 sind das optische Modul 90, beziehungsweise optische Elemente 9 des optischen Moduls 90 in Richtung der z-Achse verstellbar. Mittels der Schrauber 17 sind die Fixiermittel 12 in der x-y-Ebene in Radialrichtung verstellbar. Die Montageeinrichtung umfasst weiterhin einen Fertigungsautomaten 16, insbesondere einen Roboter, mit einem Greifarm 15, der eine Verschiebung eines erfassten Werkstücks in der x-y-Ebene und eine Drehung des Werkstücks um die x-,y-, und z-Achsen ermöglicht. Als von dem Greifarm 15 zu handhabendes Werkstück ist der Träger 4 vorgesehen. Der auf dem Greifarm 15 befestigte Träger 4 mit der auf dem Träger 4 befestigten Leiterplatte 1 und dem auf der Leiterplatte 1 angeordneten Bildsensor 3 wird in das Innere des Gehäuses 7, 13 eingeführt und durch von dem Roboter 16 gesteuerte Bewegungen des Greifarms 15 in x- und y-Richtung, beziehungsweise durch Kippbewegungen um die x-, y-, und z-Achsen auf das optische Modul 90 ausgerichtet. Dazu wird der Bildsensor 3 zweckmäßig mit einem Testbild ausgeleuchtet, das von dem optischen Modul 90 auf die lichtempfindliche Oberfläche des Bildsensors 3 projiziert wird. Eine Fokussierung erfolgt dabei durch Verstellung des optischen Moduls 90 in z-Richtung durch den Schrauber 10. Nach Erreichen einer optimalen Justierlage werden die Justiermittel 12 durch die Schrauber 17 derart verdreht, dass sie sich in Radialrichtung auf das Zentrum des Gehäuses 7,13 fortbewegen und den Träger 4 zwischen sich verspannen. Dabei bohren sich die Spitzen der Fixiermittel/Justiermittel 12 etwa einen Millimeter in den Träger 4. Auf diese Weise wird eine einmal eingestellte optimale optische Justierlage gesichert. Im bevorzugten Ausführungsbeispiel werden die Fixiermittel 12 gleichzeitig angezogen. Dabei wird das Schrauben-Drehmoment überwacht. Ferner wird die Position des Bildsensors 3 zum optischen Modul 90 überwacht und die einzelnen Fixiermittel 12 derart angezogen, dass sich die Position des Bildsensors 3 zum optischen Modul 90 unverändert bleibt oder sich zumindest innerhalb eines festgelegten Toleranzbereiches befindet. Die Fixiermittel 12 werden anschließend mit Klebstoff und/oder einem Gewindehemmer gegen Herausdrehen gesichert. Nach Lösen des Greifarms 15 von dem in dem Gehäuse 2 eingespannten Träger 4 wird das Gehäuse 2 mit dem Deckel 13 verschlossen. Das auf diese Weise fertig gestellte Bildaufnahmesystem 100 wird sodann aus der Aufnahmeeinrichtung 14 entfernt.

Figur 2 zeigt in einem Ablaufdiagramm wesentliche Schritte des Verfahrens zur Herstellung eines Bildaufnahmesystems 100 gemäß dem bevorzugten Ausführungsbeispiel nach Figur 1. Das Ablaufdiagramm gemäß Figur 2 beschränkt sich dabei auf die Schritte, die die optische Justierung des Bildsensors 3 und des optischen Moduls 90 betreffen. Vor diesen Schritten erfolgen unter anderem die Montage des optischen Moduls 90 in dem Gehäuse 7, die Befestigung des Bildsensors 3 auf der Leiterplatte 1 und die Befestigung der Leiterplatte 1 auf dem Träger 4. In einem ersten Verfahrensschritt 20 wird das Gehäuse 7 in die Aufnahmeeinrichtung 14 eingeführt und dort fixiert. In dem nächsten Schritt 21 wird der Träger 4 mitsamt der darauf befestigten Leiterplatte 1 und dem auf der Leiterplatte 1 befestigten Bildsensor 3 mittels des Greifarms 15 in das Gehäuse 7 eingeführt. In einem dritten Schritt 22 werden die optischen Achsen des optischen Moduls 90 und des Bildsensors 3 zur Deckung gebracht. Dies erfolgt zweckmäßig durch entsprechende Verschiebungen des Trägers 4 in x- und y-Richtung, sowie durch ggf. erforderliche Kippbewegungen des Trägers 4 um die x-, y-, und z-Achsen. Die erforderlichen Bewegungen werden dabei durch den Greifarm 15 des Fertigungsautomaten 16 durchgeführt. Die Ausrichtung der optischen Achsen des optischen Moduls 90 und des Bildsensors 3 erfolgt dabei zweckmäßig mit Hilfe eines Testbilds, das von dem optischen Modul 90 auf den Bildsensor 3 projiziert wird. Eine in Figur 1 mit Bezugsziffer 18 bezeichnete Auswerteeinrichtung erfasst dabei Ausgangssignale des Bildsensors 3 und gibt entsprechende Steuersignale an den Fertigungsautomaten 16 weiter. In einem nächsten Schritt 23 wird das von dem optischen Modul 90 auf den Bildsensor 3 projizierte Testbild unter Kontrolle der Auswerteeinrichtung 18 scharf gestellt. Dies erfolgt, indem der mit einem passenden Werkzeug ausgerüstete Schrauber 10 in die Fassung des optischen Moduls 90 eingreift und das optische Modul 90 durch eine Schraubbewegung in z-Richtung verstellt. Optional werden die Verfahrensschritte 22, 23 iterativ so lange wiederholt, bis die gewünschte Genauigkeit der Ausrichtung erreicht ist. In einem anschließenden Verfahrensschritt 24 wird der Träger 4 in der durch die zuvor beschriebenen Schritte erreichten optimalen Fixierlage fixiert, indem die Fixiermittel 12 durch die Schrauber 17 derart in Radialrichtung verstellt werden, dass sie den Träger 4 zwischen sich einklemmen. Im bevorzugten Ausführungsbeispiel werden die Fixiermittel 12 gleichzeitig angezogen. Dabei wird das Schrauben-Drehmoment überwacht. Ferner wird die Position des Bildsensors 3 zum optischen Modul 90 überwacht und die einzelnen Fixiermittel 12 derart angezogen, dass sich die Position des Bildsensors 3 zum optischen Modul 90 unverändert bleibt oder sich zumindest innerhalb eines festgelegten Toleranzbereiches befindet. Die Einstellung des Schraubendrehmoments und damit die Überwachung der Position des Bildsensors 3 zum optischen Modul 90 wird durch die Auswerteeinrichtung 18 in Abhängigkeit des von dem optischen Modul 90 auf den Bildsensor 3 projizierte Testbild durchgeführt. Die Fixiermittel 12 werden anschließend mit Klebstoff und/oder einem Gewindehemmer gegen Herausdrehen gesichert. In dem anschließenden Verfahrensschritt 25 wird, in Abhängigkeit von den Bilddaten des Testbilds, wenigstens ein weiterer Einstellparameter des Bildsensors 3, beispielsweise wenigstens ein Einstellparameter zur intrinsischen Kalibrierung und/oder wenigstens ein Einstellparameter der Fixed Pattern Noise Korrektur, ermittelt und gegebenenfalls eingestellt. Weitere hier im Einzelnen wiederum nicht mehr dargestellte Verfahrensschritte betreffen das Lösen des Greifarms 15 von dem Träger 4, das Verschließen des Gehäuses 2, 13 mit dem Deckel 13, und die Entnahme des fertig gestellten Bildaufnahmesystems 100 aus der Aufnahmeeinrichtung 14. Das beschriebene Bildaufnahmesystem 100 und das Verfahren zur Herstellung eines Bildaufnahmesystems sind für CCD-Bildsensoren und/oder CMOS-Bildsensoren geeignet. Eine für die Herstellung des Bildaufnahmesystems 100 besonders geeignete Fertigungseinrichtung umfasst eine Aufnahmeeinrichtung 14 zur Aufnahme eines Gehäuses 7 des Bildaufnahmesystems 100. Weiterhin umfasst die Fertigungseinrichtung verschiedene Schrauber 10, 17, die eine Justierung des optischen Moduls 90 und eine Verstellung von Fixiermitteln 12 ermöglichen. Schließlich umfasst die Fertigungseinrichtung auch noch einen Fertigungsautomaten 16 mit einem Greifarm 15, der die Bewegung eines Bestandteils (Träger 4) des Bildaufnahmesystems 100 um wenigstes fünf Achsen ermöglicht.

In einer Variante des bevorzugten Ausführungsbeispiels sind die Fixiermittel in Gewindebohrungen im Träger angeordnet und ebenfalls in Radialrichtung verstellbar. In dieser Variante greifen die Fixiermittel in innerhalb des Trägers befindlichen Elementen an, die am Gehäuse angebracht sind. Vorzugsweise sind ebenfalls wenigstens drei Fixiermittel vorgesehen, die in einem Winkelabstand von 120° auf dem Umfang eines Kreises verteilt angeordnet sind. In einer Variante sind vier Fixiermittel vorgesehen, die sich an jeder Seite eines rechteckförmigen Trägers befinden. In einer weiteren Variante sind acht Fixiermittel vorgesehen, wobei an jeder Seite des rechteckförmigen Trägers jeweils 2 Fixiermittel angeordnet sind. Ansonsten ist das Bildaufnahmesystem im wesentlich identisch aufgebaut, wie das Bildaufnahmesystem des bevorzugten Ausführungsbeispiels gemäß Figur 1. Auch die Herstellung entspricht im wesentlich dem des bevorzugten Ausführungsbeispiels gemäß Figur 2. Nachteil dieser Variante ist, dass sich die Position der Köpfe der Fixiermittel während der Ausrichtung ändern. Vorteil ist jedoch, dass das Bildaufnahmesystem kompakter ausgebildet sein kann.

## Patentansprüche

1. Bildaufnahmesystem (100) mit einem Gehäuse (7,13); mit einem in dem Gehäuse (7, 13) angeordneten optischen Modul (90), mit wenigstens einem mit dem optischen Modul (90) in optischer Wirkverbindung stehenden Bildsensor (3), wobei der Bildsensor (3) in Bezug auf das optische Modul (90) justierbar und in einer Justierlage fixierbar ist,
**dadurch gekennzeichnet, dass**
dass der Bildsensor (3) auf einer Leiterplatte (1) angeordnet ist, dass die Leiterplatte (1) auf einem Träger (4) befestigt ist und dass für die gehäusefeste Fixierung des Trägers (4) Fixiermittel (12) vorgesehen sind, die sich einerseits an dem Gehäuse (7) abstützen und andererseits den Träger (4) an seinem Außenumfang angreifen.

2. Bildaufnahmesystem (100) nach Anspruch 1, **dadurch gekennzeichnet, dass** das optische Modul (90) gehäusefest angeordnet ist.

3. Bildaufnahmesystem (100) nach einem der vorhergehenden Ansprüche, **dadurch gekennzeichnet, dass** das optische Modul (90) oder wenigstens optische Elemente (9) des optischen Moduls(90) in wenigstens einer gehäusefesten Achse (z-Achse) verstellbar sind.

4. Bildaufnahmesystem (100) nach einem der vorhergehenden Ansprüche, **dadurch gekennzeichnet, dass** der Träger (4) während eines Justiervorgangs in wenigstens einer Ebene (x-, y-Achsen) verschiebbar und um wenigstens drei Achsen (x-, y-, z-Achsen) drehbar und in einer Endlage gehäusefest fixierbar ist

5. Bildaufnahmesystem (100) nach einem der vorhergehenden Ansprüche, **dadurch gekennzeichnet, dass** die Fixiermittel (12) Madenschrauben sind, die in der Seitenwandung des Gehäuses (7) angeordneten Gewindebohrungen (11) gelagert und in Radialrichtung verstellbar sind.

6. Bildaufnahmesystem (100) nach einem der vorhergehenden Ansprüche, **dadurch gekennzeichnet, dass** die Fixiermittel (12) eine Spitze aufweisen, wobei die Spitze härter ist, als die Oberfläche des Trägers (4), an welche die Spitze angreift.

7. Bildaufnahmesystem (100) nach einem der vorhergehenden Ansprüche, **dadurch gekennzeichnet, dass** der Träger (4) aus Aluminium und/oder einer Aluminiumlegierung ist.

8. Verwendung eines Bildaufnahmesystems (100) nach einem der vorhergehenden Ansprüche in einem Fahrzeug.

9. Verfahren für die Herstellung eines Bildaufnahmesystems, insbesondere eines Bildaufnahmesystems nach einem der vorhergehenden Ansprüche, wobei ein optisches Modul (90) in einem Gehäuse (7,13) gehäusefest angeordnet wird, dass ein mit dem optischen Modul (90) in optischer Wirkverbindung stehender Bildsensor (3) auf einer Leiterplatte (1) befestigt wird, dass die Leiterplatte (1) auf einem Träger (4) befestigt wird, dass der Träger (4) mit einem Fertigungsautomaten (15, 16) in das Gehäuse (7, 13) eingebracht und dort derart ausgerichtet wird, dass der Bildsensor (3) und das optische Modul (90) aufeinander justiert sind, und dass der Träger (4) in einer Justierlage mit Fixiermitteln (12) in dem Gehäuse (7, 13) fixiert wird,
**dadurch gekennzeichnet, dass**
die optische Justierung des optischen Moduls (90) und des Bildsensors (3) mittels eines Testbilds erfolgt, das von dem optischen Modul (90) auf den Bildsensor (3) projiziert wird, und das Ausgangssignale des Bildsensors (3) erzeugt, die von einer Auswerteeinrichtung erfasst und einem Fertigungsautomaten(16) zugeleitet werden.

10. Verfahren nach Anspruch 9, **dadurch gekennzeichnet, dass** in Abhängigkeit der Bilddaten eines auf den Bildsensor (3) projizierten Testbilds wenigstens ein Einstellparameter des Bildsensors (3), beispielsweise wenigstens ein Einstellparameter zur intrinsischen Kalibrierung und/oder wenigstens ein Einstellparameter der Fixed Pattern Noise Korrektur, ermittelt und gegebenenfalls eingestellt wird.

11. Verfahren nach einem der Ansprüche 9 oder 10, **dadurch gekennzeichnet, dass** bei der Fixierung des Trägers (4) in einer Justierlage die Position des Bildsensor (3) zum optischen Modul (90) überwacht wird.

12. Verfahren nach Anspruch 11, **dadurch gekennzeichnet, dass** die Überwachung der Justierlage mittels eines Testbilds erfolgt, das von dem optischen Modul (90) auf den Bildsensor (3) projiziert wird, und das Ausgangssignale des Bildsensors (3) erzeugt, die von einer Auswerteeinrichtung erfasst und einem Fertigungsautomaten(16) zugeleitet werden.

13. Fertigungsvorrichtung für ein Bildaufnahmesystem (100) nach einem der Ansprüche 1 bis 8, umfassend eine Aufnahmeeinrichtung (14) für ein Gehäuse (7,13) des Bildaufnahmesystems (100), in Axial- und Radialrichtung wirkende Schrauber (10,17) für die Verstellung eines optischen Moduls (90) in z-Richtung und von Fixiermitteln (12) für einen Träger (4) eines Bildsensors (3) in Radialrichtung, sowie einen Fertigungsautomaten (16) mit einem um wenigstens fünf Achsen steuerbaren Greifarm (15) für die Justierung eines einen Bildsensor (3) tragenden Trägers (4) in Bezug auf ein optisches Modul (90).

14. Fertigungsvorrichtung nach Anspruch 13, **dadurch gekennzeichnet, dass** eine Auswerteeinrichtung (18) vorgesehen ist, der eingangsseitig Ausgangssignale des mit einem Testbild beaufschlagten Bildsensors (3) zuführbar sind und die ausgangsseitig mit dem Fertigungsautomat (16) für die Justierung des Trägers (4) verbunden ist.

## Claims

1. Image recording system (100) having a housing (7, 13), having an optical module (90) which is arranged in the housing (7, 13), having at least one image sensor (3) which has an optical operative connection to the optical module (90), wherein the image sensor (3) can be adjusted with respect to the optical module (90) and secured in an adjustment position, **characterized in that** the image sensor (3) is arranged on a printed circuit board (1), **in that** the printed circuit board (1) is mounted on a carrier (4), and **in that** securing means (12), which, on the one hand, are supported on the housing (7), and, on the other hand, engage on the carrier (4) on its outer circumference, are provided for securing the carrier (4) in such a way that it is fixed to the housing.

2. Image recording system (100) according to Claim 1, **characterized in that** the optical module (90) is arranged fixed to the housing.

3. Image recording system (100) according to one of the preceding claims, **characterized in that** the optical module (90) or at least optical elements (9) of the optical module (90) can be adjusted in at least one axis (z axis) which is fixed to the housing.

4. Image recording system (100) according to one of the preceding claims, **characterized in that** the carrier (4) can be displaced in at least one plane (x, y axes) during an adjustment process, and can be rotated through at least three axes (x, y, z axes), and in an end position it can be secured in such a way that it is fixed to the housing.

5. Image recording system (100) according to one of the preceding claims, **characterized in that** the securing means (12) are grub screws which are mounted in threaded bores (11) arranged in the side wall of the housing (7) and can be adjusted in the radial direction.

6. Image recording system (100) according to one of the preceding claims, **characterized in that** the securing means (12) have a tip, wherein the tip is harder than the surface of the carrier (4) on which the tip engages.

7. Image recording system (100) according to one of the preceding claims, **characterized in that** the carrier (4) is made of aluminium and/or an aluminium alloy.

8. Use of an image recording system (100) according to one of the preceding claims in a vehicle.

9. Method for manufacturing an image recording system, in particular an image recording system according to one of the preceding claims, wherein an optical module (90) is arranged in a housing (7, 13) in such a way that it is fixed to the housing, in that an image sensor (3) which has an optical operative connection to the optical module (90) is mounted on a printed circuit board (1), in that the printed circuit board (1) is mounted on a carrier (4), in that the carrier (4) is introduced by means of an automatic fabrication machine (15, 16) into the housing (7, 13) and is oriented there in such a way that the image sensor (3) and the optical module (90) are aligned with one another, and in that, in an adjustment position, the carrier (4) is secured in the housing (7, 13) with securing means (12), **characterized in that** the optical adjustment of the optical module (90) and of the image sensor (3) is carried out by means of a test image which is projected onto the image sensor (3) by the optical module (90) and which produces output signals of the image sensor (3) which are acquired by an evaluation device and fed to an automatic fabrication machine (16).

10. Method according to Claim 9, **characterized in that** at least one adjustment parameter of the image sensor (3), for example at least one adjustment parameter for intrinsic standardization and/or at least one adjustment parameter for fixed pattern noise correction are acquired and, if appropriate, set as a function of the image data of a test image which is projected onto the image sensor (3).

11. Method according to one of Claims 9 or 10, **characterized in that** when the carrier (4) is secured in an adjustment position, the position of the image sensor (3) with respect to the optical module (90) is monitored.

12. Method according to Claim 11, **characterized in that** the adjustment position is monitored by means of a test image which is projected by the optical module (90) onto the image sensor (3) and which produces output signals of the image sensor (3) which are acquired by an evaluation device and fed to an automatic fabrication machine (16).

13. Fabrication device for an image recording system (100) according to one of Claims 1 to 8, comprising a holding device (14) for a housing (7, 13) of the image recording system (100), screws (10, 17) which act in the axial and radial directions in order to adjust an optical module (90) in the z direction, and in order to adjust securing means (12) for a carrier (4) of an image sensor (3) in the radial direction, as well as an automatic fabrication machine (16) with a gripper arm (15), which can be controlled through at least five axes and has the purpose of adjusting a carrier (4) with respect to an optical module (90), said carrier (4) being fitted with an image sensor (3).

14. Fabrication device according to Claim 13, **characterized in that** an evaluation device (18) is provided, to the input side of which it is possible to feed output signals of the image sensor (3) to which a test image is supplied, said evaluation device (18) being connected on the output side to the automatic fabrication machine (16) for the purpose of adjusting the carrier (4).

## Revendications

1. Système de prise de vue (100) comprenant un boîtier (7, 13), un module optique (90) logé dans ce boîtier (7, 13), au moins un capteur d'image (3) coopérant optiquement avec le module optique (90), le capteur d'image (3) étant réglable par rapport au module optique (90) et pouvant se bloquer dans une position réglée,
**caractérisé en ce que**
le capteur d'image (3) est installé sur une plaque de circuit (1), la plaque de circuit (1) est fixée sur un support (4), et
des moyens de fixation (12) sont prévus pour bloquer le support (4) solidairement au boîtier, ces moyens de fixation s'appuyant d'un côté contre le boîtier (7) et de l'autre contre la périphérie extérieure du support (4).

2. Système de prise de vue (100) selon la revendication 1,
**caractérisé en ce que**
le module optique (90) est monté de manière solidaire au boîtier.

3. Système de prise de vue (100) selon l'une des revendications précédentes,
**caractérisé en ce que**
le module optique (90) ou au moins les éléments optiques (9) du module optique (90) sont réglables au moins suivant un axe (axe z) solidaire du boîtier.

4. Système de prise de vue (100) selon l'une des revendications précédentes,
**caractérisé en ce que**
le support (4) est coulissant au moins dans un plan (axes x, y) au cours d'une opération d'ajustage et il peut tourner suivant au moins trois axes (axes x, y, z) et se bloquer en position de fin de course solidairement au boîtier.

5. Système de prise de vue (100) selon l'une des revendications précédentes,
**caractérisé en ce que**
le moyen de fixation (12) est constitué par des vis sans tête logées dans des taraudages (11) prévus dans la paroi latérale du boîtier (7) et réglables dans la direction radiale.

6. Système de prise de vue (100) selon l'une des revendications précédentes,
**caractérisé en ce que**
les moyens de fixation (12) comportent une pointe plus dure que la surface du support (4) contre laquelle vient la pointe.

7. Système de prise de vue (100) selon l'une des revendications précédentes,
**caractérisé en ce que**
le support (4) est en aluminium ou en un alliage d'aluminium.

8. Utilisation d'un système de prise de vue (100) selon l'une des revendications précédentes dans un véhicule automobile.

9. Procédé de fabrication d'un système de prise de vue, notamment d'un système de prise de vue selon l'une des revendications précédentes, selon lequel :
on installe un module optique (90) solidairement dans un boîtier (7, 13), un capteur d'image (3) coopérant optiquement avec le module optique (90) est fixé sur une plaque de circuit (1),
la plaque de circuit (1) est fixée sur un support (4),
le support (4) est mis dans le boîtier (7, 13) à l'aide d'un automate de fabrication (15, 16) et y est aligné pour que le capteur d'image (3) et le module optique (90) soient réglés l'un par rapport à l'autre et que le support (4) soit bloqué en position ajustée avec les moyens de fixation (12) dans le boîtier (7, 13),
**caractérisé en ce que**
l'ajustage optique du module optique (90) et du capteur d'image (3) se fait à l'aide d'une image de contrôle projetée par le module optique (90) sur le capteur d'image (3), et générant des signaux de sortie du capteur d'image (3) saisis par une installation d'exploitation et fournis à un automate de fabrication (16).

10. Procédé selon la revendication 9,
**caractérisé en ce qu'**
en fonction des données d'image d'une image de contrôle projetée sur le capteur d'image (3), on détermine et le cas échéant on règle au moins un paramètre de réglage du capteur d'image (3) par exemple au moins un paramètre de réglage de calibrage intrinsèque et/ou d'au moins un paramètre de réglage de correction du motif de bruit fixe.

11. Procédé selon l'une des revendications 9 ou 10,
**caractérisé en ce qu'**
en fixant le support (4) dans une position ajustée, on surveille la position du capteur d'image (3) par rapport au module optique (90).

12. Procédé selon la revendication 11,
**caractérisé en ce qu'**
on surveille la position ajustée à l'aide d'une image de contrôle projetée par le module optique (90) sur le capteur d'image (3), et on génère les signaux de sortie du capteur d'image (3) qui sont saisis par une installation d'exploitation et sont transmis à un automate de fabrication (16).

13. Dispositif de fabrication d'un système de prise de vue (100) selon l'une des revendications 1 à 8, comprenant une installation de réception (14) pour un boîtier (7, 13) du système de prise de vue (100), des moyens de vissage (10, 17) agissant dans la direction axiale et dans la direction radiale pour régler un module optique (90) dans la direction (z) et le moyen de fixation (12) du support (4) d'un capteur d'image (3) dans la direction radiale ainsi qu'un automate de fabrication (16) muni d'un bras de préhension (15) commandé suivant au moins cinq axes pour l'ajustage du support (4) portant le capteur d'image (3) par rapport à un module optique (90).

14. Dispositif de fabrication selon la revendication 13,
**caractérisé par**
une installation d'exploitation (18) recevant en entrée des signaux de sortie du capteur d'image (3) sollicités par l'image de contrôle et reliés en sortie à l'automate de fabrication (16) pour ajuster le support (4).
